Europäisches Patentamt

European Patent Office

Office européen des brevets

(19)

(11) **EP 0 507 288 B1**

(12) **EUROPEAN PATENT SPECIFICATION**

(45) Date of publication and mention
of the grant of the patent:
**14.02.1996 Bulletin 1996/07**

(51) Int Cl.$^6$: **G01R 33/46**

(21) Application number: **92105646.1**

(22) Date of filing: **02.04.1992**

(54) **Method for editing CPMAS solid-state NMR spectra**

Methode zur Aufbereitung von CPMAS-NMR-Spektren

Méthode d'édition de spectres RMN de solides obtenus par CPMAS

(84) Designated Contracting States:
**CH DE FR GB LI**

(30) Priority: **05.04.1991 US 681571**

(43) Date of publication of application:
**07.10.1992 Bulletin 1992/41**

(73) Proprietor: **BRUKER INSTRUMENTS, INC.
Billerica, Massachusetts 01821 (US)**

(72) Inventor: **Bielecki, Anthony J., Dr.
Sommerville, Massachusetts 02144 (US)**

(74) Representative: **KOHLER SCHMID + PARTNER
D-70565 Stuttgart (DE)**

(56) References cited:
**EP-A- 0 467 704**

- **CHEMICAL PHYSICS LETTERS, vol. 100, no. 4,
September 1983, AMSTERDAM, NL pages 305 -
310; P. CARAVATTI ET AL.: 'Heteronuclear
Correlation Spectroscopy in Rotating Solids'**
- **CHEMICAL PHYSICS LETTERS, vol. 89, no. 5,
July 1982, AMSTERDAM, NL pages 363 - 367;
P. CARAVATTI ET AL.: 'Heteronuclear
Solid-State Correlation Spectroscopy'**
- **JOURNAL OF THE AMERICAN CHEMICAL
SOCIETY. vol. 101, no. 19, September 1979,
GASTON, USA pages 5854 - 5856; S.J. OPELLA,
M.H. FREY: 'Selection of Non-Protonated
Carbon Resonances in Solid-State Nuclear
Magnetic Resonance'**
- **JOURNAL OF MAGNETIC RESONANCE, vol.
81, no. 3, February 1989, DULUTH, USA pages
500 - 511; N. CHR. NIELSEN ET AL.: 'Spectral
Editing of 13C NMR Spectra via
Two-Dimensional Pulse Techniques'**
- **JOURNAL OF MAGNETIC RESONANCE, vol.
89, no. 1, August 1990, DULUTH, USA pages
205 - 209; R. TYCKO ET AL.: 'Carbon-13
Zero-Field NMR in High Field'**
- **D.W. JONES : "NMR examinatin of fossil fuels",
TRAC 2, 83-86 (1983)**

## Description

### Field of the Invention

This invention relates to solid-state NMR spectroscopy and, in particular, to radio-frequency pulse sequences for selectively suppressing resonance lines in CPMAS spectra.

### Background of the Invention

Nuclear magnetic resonance (NMR) is a phenomenon exhibited by a select group of atomic nuclei and is based upon the existence of nuclear magnetic moments in these nuclei (termed "gyromagnetic" nuclei). When a gyromagnetic nucleus is placed in a strong, uniform and steady magnetic field (a so-called "Zeeman field") and perturbed by means of a weak radio-frequency (RF) magnetic field, it precesses at a natural resonance frequency known as a Larmor frequency, which is characteristic of each nuclear type and is dependent on the applied field strength in the location of the nucleus. Typical gyromagnetic nuclei include $^1H$ (protons), $^{13}C$, $^{19}F$ and $^{31}P$. The resonant frequencies of the nuclei can be observed by monitoring the transverse magnetization which results after a strong RF pulse. It is common practice to convert the measured signal to a frequency spectrum by means of Fourier transformation.

Although identical nuclei have the same frequency dependence upon the magnetic field, differences in the chemical environment of each nucleus can modify the applied magnetic field in the local vicinity of the nucleus, so that nuclei in the same sample do not experience the same net magnetic field. The differences in the local magnetic field result in spectral shifts in the Larmor frequencies between two such chemically non-equivalent nuclei, called "chemical shifts". These chemical shifts are interesting in that they reveal information regarding the number and placement of the atoms in a molecule and in the positioning of adjacent molecules with respect to each other in a compound.

Unfortunately, it is not always possible to interpret the frequency spectra produced by the chemical shifts because of other interfering and dominant interactions.

This is particularly true in NMR spectroscopy of solids. In liquid NMR spectroscopy, the rapid motion of the liquid molecules tends to isolate the nuclei and separate the nuclear interactions, so that it is easier to distinguish separate nuclei in the final output. In solid state NMR, there are many interactions between the molecules which obscure the output. For example, the magnetic moments in neighboring nuclei perturb each other, resulting in interactions called dipole-dipole couplings. These couplings tend to broaden the characteristic resonance peaks and obscure the "fine" resonant structure produced by the chemical shifts. An additional problem found in solids, which is not present in liquids, is that the orientation of the solid molecules is relatively fixed with respect to the applied Zeeman field and, accordingly, the chemical shifts are anisotropic, in that a component of the resonant frequency depends on the physical orientation of the molecules with respect to the applied field.

Therefore, it is essential to suppress some interactions over others to obtain a meaningful output. This is usually done by perturbing the system at selected frequencies to cause unwanted interactions to cancel or average to a reduced amplitude. For example, in solids, the aforementioned chemical shift anisotropy is usually greatly reduced by orienting the solid sample at a "magic angle" (54°44') with respect to the applied Zeeman field and physically rotating the solid at a relatively rapid rate causing the anisotropic field components to average to zero.

Similarly, by well-known techniques, it is possible to reduce the unwanted spin-spin interactions by irradiating the nuclei with additional pulses of RF energy at or near the Larmor frequencies. By properly selecting various orientations and phases of the RF pulses, the polarization of the perturbing nuclear spin systems in neighboring groups can be changed, effectively averaging out the spin interactions so that the contribution to the final output is greatly diminished. Since the Larmor frequencies for each nuclear type are distinct, an applied RF frequency will have a much greater effect on those nuclei which have a Larmor frequency which is close to the applied frequency than those nuclei in which the Larmor frequency is considerably different. Thus, the applied RF fields can be used to affect one type of nucleus while leaving others unchanged.

A conventional NMR technique which is used obtain NMR spectra of organic solids involves obtaining an output from $^{13}C$ nuclei in the solid of interest. However, the $^{13}C$ nuclei are not directly excited. Instead, $^1H$ nuclei (protons) in the test sample are excited and various RF pulse sequences are used to transfer polarization from the protons to the $^{13}C$ nuclei which are then observed. This technique is carried out in the presence of magic angle spinning and is referred to as Cross-Polarized Magic Angle Spinning or CPMAS. The technique is described in more detail in "Solid State NMR for Chemists", Colin A. Fyfe, CFC Press, P.O. Box 1720, Guelph, Ontario, Canada N1H 6Z9, Chapter 6 and "High Resolution Solid-State NMR of Carbon-13", R.G. Griffin, Analytical Chemistry, v. 49, p. 951A (1977) and generally involves performing a process or "experiment" in the time domain, consisting of three time intervals. During the first time period, the sample protons are placed in a excited, coherent non-equilibrium state by the application of a single RF pulse to the sample, or by a sequence of RF pulses.

Next, the sample is subject to cross-polarization during which RF pulses or continuous RF energy is applied to both the protons and the $^{13}C$ nuclei, which causes the transfer of coherence or polarization from the protons to the $^{13}C$ nuclei under observation.

The cross-polarization period is followed by data acquisition in which the cross-polarizing energy is removed and a free induction decay (FID) occurs in the $^{13}C$ nuclei and the resonance frequencies of the $^{13}C$ nuclei are measured. During this period it is conventional to apply further pulses or continuous wave RF energy to the protons in order to decouple or prevent further interaction of the protons and $^{13}C$ nuclei. It is also possible to interrupt the irradiation of the protons with decoupling radiation at the first species Larmor frequency and then to continue the irradiation.

For many solid materials, the CPMAS technique produces well-differentiated spectra of the carbon nuclei in the test sample with good chemical shift resolution. The CPMAS spectra appear very similar to $^{13}C$ NMR spectra of samples in solution, and they are used in much the same way.

However, in some cases, it is convenient to suppress some information in favor of other information. For example, the carbon atoms in a particular sample may be arranged so that resonance peaks or lines overlap and obscure each other. Alternatively, it may be desirable to differentiate the carbon resonance lines or spins, for example, by the number of directly bonded protons. In this manner, additional information can be gathered about the molecular structure.

The carbon spins typically can be differentiated by means of various spectral "editing" techniques. In $^{13}C$ NMR spectroscopy of liquid samples, various well-known editing techniques are commonly used to differentiate carbon spins according to the number of directly bonded protons. An example of such a technique is the so-called DEPT RF pulse sequence described in "Proton-polarization Transfer Enhancement of a Heteronuclear Spin Multiplet with Preservation of Phase Coherency and Relative Component Intensities", D. T. Pegg, D.M. Doddrell, M.R. Bendall, Journal of Chemical Physics, v. 77, n. 6, pp. 2745-2752 (1982). The DEPT technique can differentiate between resonances resulting from CH, $CH_2$ and $CH_3$ functional groups.

However, only a few prior art spectral editing methods have been used for solid-state CPMAS experiments; one common such prior art editing technique is called dipolar dephasing and is described in "Selection of Non-Protonated Carbon Resonances in Solid-State Nuclear Magnetic Resonance", S.J. Opella, D.M.H. Frey, Journal of the American Chemical Society, v. 101, p. 5855 (1979). In this editing method, the $^{13}C$-proton decoupling energy is interrupted briefly just before the start of data acquisition. The result is that the carbon spins which have one or more attached protons are suppressed in the output, while non-protonated carbons are largely unaffected. This technique is useful, but it does not differentiate between the carbons that have one or more attached protons (CH, $CH_2$ and $CH_3$ groups).

Other, so-called "difference" prior art spectral editing techniques have been proposed as described in "Quantitative Determination of the Concentrations of $^{13}C$-$^{15}N$ Chemical Bonds by Double Cross-Polarization NMR", J. Schaefer, E.O. Stejskal, J.R. Garbow and R.A. McKay, Journal of Magnetic Resonance, V. 59, pp. 150-156 (1984) and "Magic-Angle-Sample-Spinning NMR Difference Spectroscopy", H.J.M. DeGroot, V. Copie, S. O. Smith, P.J. Allen, C. Winkle, J. Lugtenburg, J. Herzfeld and R.G. Griffin, Journal of Magnetic Resonance, v. 77, pp. 251-257 (1988), but they typically depend on either the presence of a third nuclear species or on isotopic enrichment and labeling, and are therefore useful only in special cases.

Accordingly, it is an object of the present invention to provide editing of conventional CPMAS solid-state NMR spectra.

It is another object of the present invention to increase the number of carbon sites which can be resolved in conventional CPMAS solid-state NMR spectra.

It is still another object of the present invention to provide editing of conventional CPMAS solid-state NMR spectra by modifying the proton decoupling portion of a conventional CPMAS solid-state NMR experiment.

It is yet another object of the present invention to provide a editing of conventional CPMAS solid-state NMR spectra by modifying the proton decoupling energy during the acquisition of data.

It is a further object of the present invention to provide a new RF pulse sequences during the cross-polarization period to effectively suppress carbon resonances other than methylene carbons.

## Summary of the Invention

The foregoing problems are solved and the foregoing objects are achieved in the invention, in which the normal CPMAS experiment is modified to provide for spectral editing.

In the invention the RF pulse sequence normally using during the cross-polarization period is replaced with another new sequence which has the effect of suppressing the CH and $CH_3$ resonances, thereby leaving the $CH_2$ resonances.

## Brief Description of the Drawing

Figure 1A schematically illustrates the proton channel of a conventional CPMAS experiment indicating the RF energy applied to the protons.

Figure 1B schematically illustrates the carbon channel of a conventional CPMAS experiment indicating the RF energy applied to the $^{13}C$ nuclei.

Figure 2A schematically illustrates the proton channel of a CPMAS experiment modified in accordance with the invention indicating the RF energy applied to the protons.

Figure 2B schematically illustrates the carbon channel of a CPMAS experiment modified in accordance with the invention indicating the RF energy applied to the $^{13}C$ nuclei.

Figure 2C schematically illustrates the WIM sequence applied to the protons for cross-polarization in the experiment illustrated by Figures 2A and 2B.

Figure 2D schematically illustrates the WIM sequence applied to the $^{13}C$ nuclei for cross-polarization in the experiment illustrated by Figures 2A and 2B.

Figure 3A shows a sucrose spectrum of signal amplitude versus frequency obtained in the CPMAS experiment illustrated in Figures 2A-2D in which the rotor period was set equal to three times the WIM sequence time and the spectra was obtained after four WIM sequences.

Figure 3B shows a sucrose spectrum of signal amplitude versus frequency obtained in the CPMAS experiment illustrated in Figures 2A-2D in which the rotor period was set equal to three times the WIM sequence time and the spectra was obtained after three WIM sequences.

Figure 3C is a composite signal spectrum diagram of signal amplitude versus frequency obtained by subtracting the signal amplitudes of the spectrum shown in Figure 3B from the signal amplitudes of the spectrum shown in Figure 3A with slight adjustments.

Figure 3D is a composite signal spectrum diagram of signal amplitude versus frequency obtained by subtracting the signal amplitudes of the spectrum shown in Figure 3A from doubled signal amplitudes of the spectrum shown in Figure 3B with slight adjustments.

Figure 4A shows a polystyrene spectrum of signal amplitude versus frequency obtained in the CPMAS experiment illustrated in Figures 2A-2D in which the rotor period was set equal to three times the WIM sequence time and the spectra was obtained after four WIM sequences.

Figure 4B shows a polystyrene spectrum of signal amplitude versus frequency obtained it the CPMAS experiment illustrated in Figures 2A-2D in which the rotor period was set equal to three times the WIM sequence time and the spectra was obtained after three WIM sequences.

Figure 4C is a composite signal spectrum diagram of signal amplitude versus frequency obtained by subtracting the signal amplitudes of the spectrum shown in Figure 4B from the signal amplitudes of the spectrum shown in Figure 4A with slight adjustments.

Figure 4D is a composite signal spectrum diagram of signal amplitude versus frequency obtained by subtracting the signal amplitudes of the spectrum shown in Figure 4A from doubled signal amplitudes of the spectrum shown in Figure 4B with slight adjustments.

## Detailed Description of the Preferred Embodiments

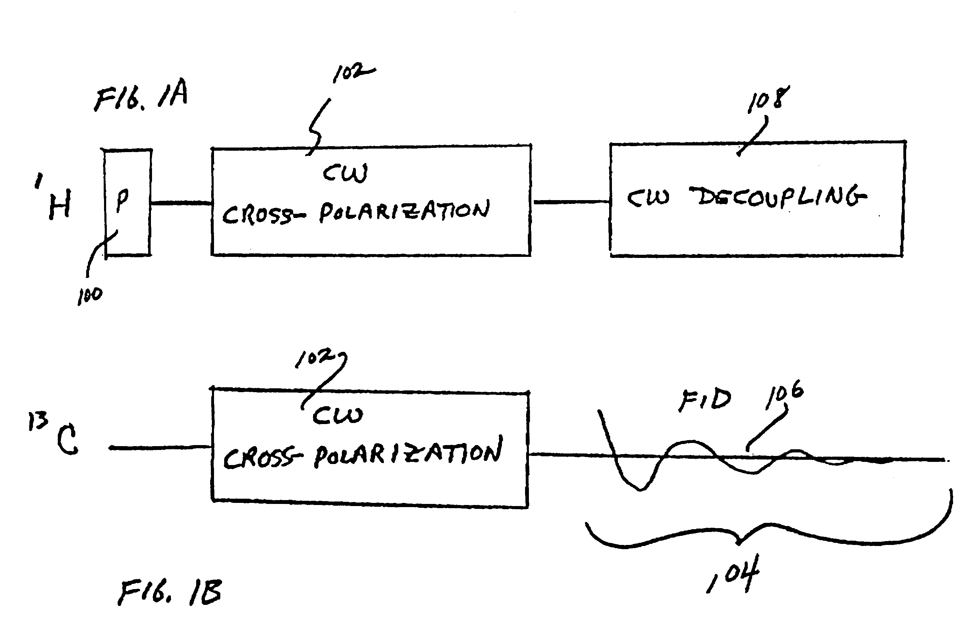

A conventional CPMAS experiment is schematically illustrated in Figures 1A and 1B which shown the proton and carbon channels, respectively. Figures 1A and 1B show only the RF portion of the experiment. During the entire experiment, the test sample is placed in a rotor with an axis canted at the magic angle to the applied main Zeeman field and rotated at high speed in a conventional fashion.

During the first time period, the sample protons are placed in a excited, coherent non-equilibrium state by the application of a single RF $\pi$ pulse 100 to the sample in a known fashion. No RF energy is applied to the carbon nuclei at this time.

Next, the sample is subjected to cross-polarization energy during which continuous-wave RF energy, 102, is applied to both the protons and the $^{13}C$ nuclei at the respective resonant frequencies. Typically, the continuous energy amplitudes are adjusted to meet a condition known as the "Hartmann-Hahn" condition as is well-known.

The cross-polarization period is followed by a data acquisition period 104 in which the cross-polarizing energy is removed and an FID 106 occurs in the $^{13}C$ nuclei and the resonance frequencies of the $^{13}C$ nuclei are measured. During this period it is conventional to apply continuous wave RF decoupling energy 108 at the proton resonance frequency to the protons.

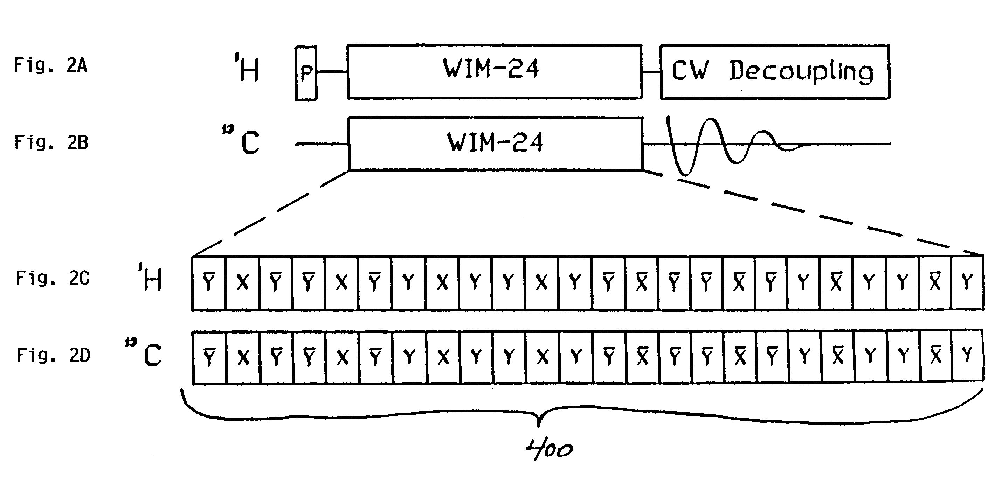

However, in accordance with the invention, when the WIM pulse sequence illustrated in Figures 2C and 2D is applied simultaneously to both the protons and carbons in the CPMAS experiment, the pulse sequence has the effect of isolating the protons from each other while allowing the protons and carbons to remain coupled.

More particularly, in Figures 2C and 2D, each box in the sequence which is designated with an X or Y marking comprises a single RF pulse applied to the system. By convention, the applied fields are referenced to a Cartesian coordinate system with the applied Zeeman field pointing along the Z-axis. Accordingly, the applied RF fields are polarized 90° to the Zeeman field or along the X and Y axes. Since the X and Y axes are arbitrary directional designations, the pulse designations of X and Y are taken to represent relative phases of the signals. For example a RF pulse-designated as an X pulse has a relative phase shift of 90° with respect to an RF pulse designated as a Y pulse. Similarly, an RF pulse designated as X or -X has a relative phase shift of 180° with respect to an X pulse. In addition to applying the WIM sequence, the rotation rate of the sample is adjusted such that the rotor rotation period is an integral number of WIM cycle times 400.

In effect, the isolation of the protons causes the sample to appear in the NMR experiment as an ensemble of isolated $CH$, $CH_2$ and $CH_3$ spin groups. Of course, there remain direct couplings between carbon spins and more distant protons, but these can be largely ignored for the short time periods used in this second embodiment.

In the drawings, -X and -Y are written as $\overline{X}$ and $\overline{Y}$, respectively.

The spectral editing effect of the illustrative method may be understood by considering in detail the effect of magic angle spinning on the heteronuclear dipolar coupling of isolated CH and $CH_2$ groups. As before, this interaction is described by the heteronuclear dipolar Hamiltonian $H_{is}$. For the CH group, the heteronuclear dipolar Hamiltonian $H_{is}$ under the influence of the WIM cross-polarization sequence is given by:

$$H_{is} = \beta I_Z S_Z (1 - 3 \cos^2 \Theta) \tag{3}$$

where $\beta$ is constant describing the coupling strength between the proton and carbon nucleus, $I_Z$ is a spin operator for the proton, $S_Z$ is a spin operator for the carbon nucleus and $\Theta$ is the MAS rotor angle with respect to the applied Zeeman field.

Because the change over time of the complete Hamiltonian is complex, it is advantageous to use a simplification known as average Hamiltonian theory. Average Hamiltonian theory is a known simplification which is described in more detail in an article by U. Haeberlen and J.S. Waugh, <u>Physical Review,</u> v. 175, p. 453 (1968); "Advances in Magnetic Resonance", U. Haeberlen, v. 12, suppl. 1, edited by J.S. Waugh, Academic Press (1982) and "Transient Techniques in NMR of Solids", B.C. Gerstein and C.R. Dybowski, Academic Press (1985), which article and references are hereby incorporated by reference.

More particularly, if a Hamiltonian is assumed to be piecewise constant and periodic, average Hamiltonian theory takes on a particularly simple form in which a propagator is defined as

$$U(\tau_c) = \exp(-iH_n t_n) \exp(-iH_{n-1} t_{n-1}) \ldots \exp(-iH_1 t_1), \tag{4}$$

where $H_n$ is the active Hamiltonian during the nth time interval. When the products in equation (4) commute, that is, can be interchanged in order without affecting the overall result, Average Hamiltonian Theory allows the time-dependent products in Equation (4) to be replaced with a simple propagator of the form

$$U(\tau_c) = \exp(-i\overline{H}(\tau_c)\tau_c). \tag{5}$$

Where $\overline{H}(\tau_c)$ is the time-averaged Hamiltonian. Therefore, the time-dependent term can be replaced by its time-average without affecting the overall result.

Considering the heteronuclear dipolar Hamiltonian expressed in Equation (3), as the sample rotates only the value of $\Theta$ changes. The Hamiltonian $H_{is}$ will therefore commute with itself at all times, and the effect of the time-dependent Hamiltonian can be exactly described by its time-averaged value, which is zero. In practice, this means that for a CH group, there will be no cross-polarization from the protons to the carbons at times which are an integral multiple of the rotor period. The magnetization may flow back and forth during the rotation, but it will always totally "echo" back to the protons at the end of each rotation.

For each $CH_2$ group, the situation is somewhat different. The heteronuclear dipolar Hamiltonian $H_{is}$ in this case is given by

$$H_{is} = \beta_1 I_{z1} S_z (1 - 3 \cos^2 \Theta_1)$$

$$+$$

$$\beta_2 I_{z2} S_z (1 - 3 \cos^2 \Theta_2) \tag{6}$$

where the subscripts 1 and 2 refer to the two protons.

Since, in general, the terms $\beta_1(1 - 3\cos^2\Theta_1)$ and $\beta_2(1 - 3\cos^2\Theta_2)$ will not be equal, the magnetization will not "echo" back to the protons at the end of each rotor rotation. However, the magnetization can be expected to rapidly reach a state of thermal equilibrium between the two spin systems, in much the same way it does when the conventional Hartmann-Hahn cross polarization is used in a CPMAS experiment.

For methyl ($CH_3$) groups, the result is typically the same as for CH groups, since rapid thermal molecular rotation normally causes the effective values of $\beta_1$, $\beta_2$ and $\beta_3$ and of $\Theta_i$, $\Theta_2$ and $\Theta_3$ to be equal, with the result that the heteronuclear dipolar Hamiltonian commutes with itself at all times and can be replaced with its time average which is zero.

With the above properties of the applicable heteronuclear dipolar Hamiltonian, the editing effect of the WIM pulse sequence becomes immediately clear. If the system is allowed to cross-polarize under simultaneous proton and carbon WIM excitation for an integer number of rotor periods, theoretically, only the methylene resonances should appear in the output. In actual practice, complete suppression of the CH and $CH_3$ resonances does not occur for two reasons. First, the theoretical discussion does not take into account direct dipolar coupling between the CH and $CH_3$ carbons and more distant protons. Second, the WIM sequence itself is not perfect. Although the sequence removes most of the proton-proton coupling, some coupling between protons will remain due to higher order terms in the WIM average Hamiltonian which are not completely time averaged to zero, and due to interference between the WIM pulse sequence and the sample rotation.

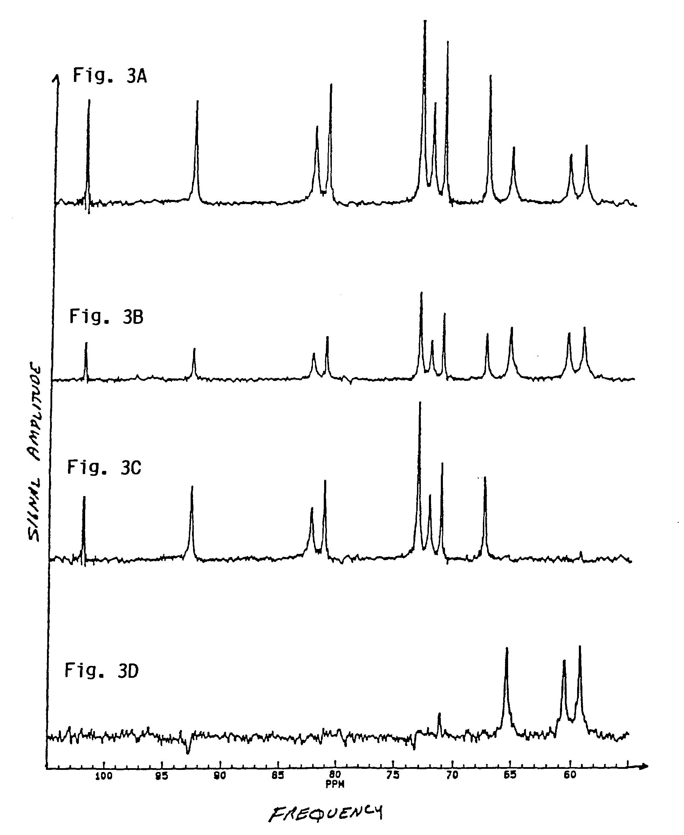

Under typical experimental conditions, there is time for only two or three complete WIN cycles during a single rotor rotation. Figures 3A-3D show a CPMAS spectra of sucrose in which the WIM pulse sequence was used for cross-polarization and decoupling energy was applied at the proton resonance frequency and the rotor period was adjusted to be exactly three times the WIM cycle time. Accordingly, the CH and $CH_3$ resonances should be suppressed at outputs taken at integral multiples of the rotor period.

Figure 3A shows an output spectra taken after four WIM cycles and thus it is not an a rotor period multiple. Figure 3B shows a spectra taken after three WIM cycles or at a rotor period multiple. According to the theoretical analysis above, the CH and $CH_3$ resonances should be suppressed in the Figure 3B spectrum. A comparison of the Figures 3A and 3B spectra clearly shows a selective suppression of the non-methylene resonance lines when the system was allowed to cross polarize for exactly one rotor period as shown in Figure 3B.

The selectivity is best seen from a difference spectrum shown in Figure 3C, obtained by simply subtracting the spectrum shown in Figure 3B from that shown in Figure 3A without any adjustment of the relative spectral amplitudes. As shown in Figure 3C, in the difference spectrum, only the non-methylene lines appear. On the other hand, doubling the amplitude of the Figure 3B spectrum before subtracting the Figure 3A spectrum results in a difference spectrum, shown in Figure 3D, in which only the methylene resonances appear.

The spectral editing properties of the invention are not degraded by line broadening caused by sample inhomogeneity or other resonance line broadening factors, nor do they depend on the relative strengths of the heteronuclear dipolar couplings. Therefore, the invention can successfully edit spectra in many difficult cases such as polystyrene. For example Figures 4A-4D present spectral results for polystyrene using the second inventive embodiment.

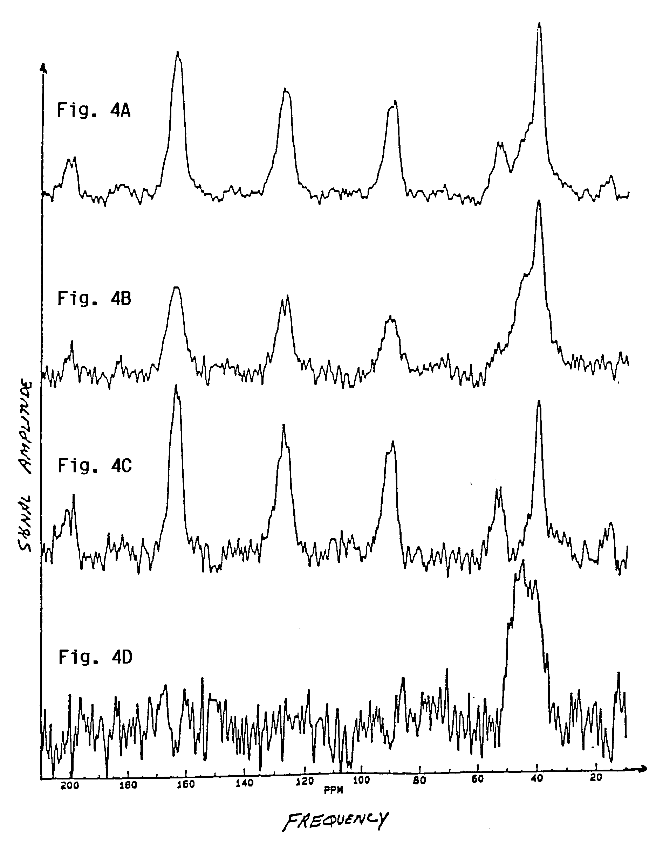

Figure 4A in shows an output spectra taken after four WIM cycles and thus it is not a rotor period multiple. Figure 4B shows a spectra taken after three WIM cycles or at a rotor period multiple. Figure 4C shows a difference spectrum obtained by subtracting the spectrum shown in Figure 4B from that shown in Figure 4A with some adjustment of the relative spectral amplitudes and Figure 4D shows a difference spectrum obtained by doubling the amplitude of the Figure 4B spectrum before subtracting the Figure 4A spectrum and adjusting the relative signal amplitudes.

It can be clearly seen in Figures 4C and 4D that the only methylene resonance is the broad line at a frequency of 45 ppm. In this instance, the second inventive embodiment serves not only to identify the methylene resonance, but also to deconvolute it from an overlapping methyl resonance at a frequency of 42 ppm.

Although only one embodiment of the inventive method has been described, several modifications and changes will be immediately apparent to those skilled in the art. For example, the inventive method may be used in combination with conventional dipolar dephasing editing techniques. Although the above discussion has been in terms of cross-polarization between protons and $^{13}C$ nuclei, the inventive methods are also applicable to heteronuclear cross-polarization experiments involving other nuclei as well. In addition, the inventive methods can also be combined in a straightforward way with spinning sideband suppression techniques such as SELTICS and TOSS.

These modifications and other obvious changes are intended to be covered by the following claims.

## Claims

1. A method for recording a one-dimensional spectrum in a solid state, cross-polarization magic angle spinning NMR experiment involving a first nuclear species and a second nuclear species wherein the sample is rotated at a fixed rotation frequency and the first nuclear species is excited with at least one radio-frequency preparation pulse; the first nuclear species and the second nuclear species are subsequently irradiated with cross-polarization radiation and the first nuclear species is irradiated with decoupling radiation while transverse magnetization is being detected from the second nuclear species, the cross-polarization radiation comprising at least one radio-frequency pulse sequence having a predetermined time duration and composed of twenty-four 90° radio frequency pulses having the relative phases:

-Y, X, -Y, -Y, X, -Y, Y, X, Y, Y, X, Y, -Y, -X -Y, -Y, -X, -Y, -X, Y, Y, -X, Y where the phase of an X pulse differs from the phase of a Y pulse by 90°, the phase of an X pulse differs from the phase of a -X pulse by 180° and the phase of a Y pulse differs from the phase of a -Y pulse by 180°; the sample rotation frequency is adjusted so that the rotation period is an integer multiple 1 of the radio-frequency pulse sequence time duration; and a spectrum is recorded after an integer multiple of 1 pulse sequences for spectral editing.

2. The spectral editing method according to claim 1, wherein the first nuclear species is irradiated with cross-polarization radiation at the first species Larmor frequency during a first predetermined time duration; and the second nuclear species is irradiated with cross-polarization radiation at a second species Larmor frequency during a second predetermined time duration.

3. The spectral editing method according to Claim 2, wherein the second predetermined time duration is equal to the first predetermined time duration.

4. The spectral editing method according to claim 2, wherein pulse or continuous-wave cross-polarization radiation is applied to both the first and the second nuclear species and, after the cross-polarization radiation has been switched off, transverse magnetization is detected from the second nuclear species while decoupling radiation is being applied to the first nuclear species.

5. The spectral editing method according to Claim 4, wherein the irradiation of the first nuclear species with decoupling radiation at the first species Larmor frequency is temporarily interrupted and then continued.

6. The spectral editing method according to any of the preceding claims, wherein the first nuclear species is a proton and the second nuclear species is a carbon nucleus.

7. The spectral editing method according to any of the preceding claims, wherein the sample rotation frequency is adjusted so that the rotation period is equal to three times the radio-frequency pulse sequence time duration.

**Patentansprüche**

1. Verfahren zum Aufzeichnen eines eindimensionalen Spektrums in einem Festkörper-NMR-Experiment mit Polarisationsüberkreuzung (cross-polarization) und Rotation um den magischen Winkel, welches eine erste Kernsorte und eine zweite Kernsorte umfaßt, wobei die Probe bei einer festen Rotationsfrequenz rotiert wird und die erste Kernsorte mit mindestens einem Hochfrequenz-Vorbereitungsimpuls angeregt wird, die erste Kernsorte und die zweite Kernsorte nachfolgend mit Polarisationsüberkreuzungs-Strahlung bestrahlt werden und die erste Kernsorte mit einer Entkopplungs-Strahlung bestrahlt wird, während eine transversale Magnetisierung von der zweiten Kernsorte detektiert wird, wobei die Polarisationsüberkreuzungs-Strahlung mindestens eine Hochfrequenz-Impulsfolge aufweist mit einer vorbestimmten Zeitdauer, die aus vierundzwanzig 90° Hochfrequenzimpulsen zusammengesetzt ist, die die relativen Phasen haben:
-Y, X, -Y, -Y, X, -Y, Y, X, Y, Y, X, Y, -Y, -X -Y, -Y, -X, -Y, Y, -X, Y, Y, -X, Y wobei die Phase eines X-Impulses sich von der Phase eines Y-Impulses um 90°, die Phase eines X-Impulses sich von der Phase eines -X-Impulses um 180° und die Phase eines Y-Impulses sich von der Phase eines -Y-Impulses um 180° unterscheiden, wobei die Proben-Rotationsfrequenz so eingestellt ist, daß die Rotationsperiode ein ganzzahliges Vielfaches 1 der Zeitdauer der Hochfrequenz-impulsfolge ist, und wobei ein Spektrum nach einem ganzzahligen Vielfachen von 1 Impulsfolgen für spektrales Editieren aufgezeichnet wird.

2. Spektrales Editierverfahren nach Anspruch 1, wobei die erste Kernsorte mit Polarisationsüberkreuzungs-Strahlung bei der Larmorfrequenz der ersten Sorte während einer ersten vorbestimmten Zeitspanne bestrahlt wird, und die zweite Kernsorte mit einer Polarisationsüberkreuzungs-Strahlung bei der Larmorfrequenz einer zweiten Sorte während einer zweiten vorbestimmten Zeitspanne bestrahlt wird.

3. Spektrales Editierverfahren nach Anspruch 2, wobei die zweite vorbestimmte Zeitspanne gleich der ersten vorbestimmten Zeitspanne ist.

4. Spektrales Editierverfahren nach Anspruch 2, wobei Polarisationsüberkreuzungs-Strahlung in Form von Impulsen oder kontinuierlichen Wellen sowohl auf die erste als auch auf die zweite Kernsorte angewandt wird, und nachdem die Polarisationsüberkreuzungs-Strahlung abgeschaltet wurde, eine transversale Magnetisierung von der zweiten Kernsorte detektiert wird, während eine Entkopplungs-Strahlung auf die erste Kernsorte angewandt wird.

5. Spektrales Editierverfahren nach Anspruch 4, wobei die Bestrahlung der ersten Kernsorte mit Entkopplungs-Strahlung bei der Larmorfrequenz der ersten Sorte vorübergehend unterbrochen wird und dann fortgesetzt wird.

**6.** Spektrales Editierverfahren nach einem der vorhergehenden Ansprüche, wobei die erste Kernsorte ein Proton und die zweite Kernsorte ein Kohlenstoffkern ist.

**7.** Spektrales Editierverfahren nach einem der vorhergehenden Ansprüche, wobei die Rotationsfrequenz der Probe so eingestellt wird, daß die Rotationsperiode drei mal so lang ist wie die zeitliche Dauer der Hochfrequenz-Impulsfolge.

## Revendications

**1.** Procédé pour enregistrer un spectre unidimensionnel dans une expérience à résonance magnétique nucléaire (RMN) de spin à l'état solide à angle magique de polarisation croisée, comprenant une première nucléide et une deuxième nucléide dans lesquelles l'échantillon est mis en rotation à une fréquence de rotation fixe et la première nucléide est excitée par au moins une impulsion préparatoire de radiofréquence, la première nucléide et la deuxième nucléide sont consécutivement irradiées par une radiation à polarisation croisée et la première nucléide est irradiée par une radiation de découplage tandis qu'une magnétisation transversale est détectée à partir de la deuxième nucléide, la radiation à polarisation croisée comprenant au moins une séquence d'impulsions de radiofréquence ayant une durée en temps prédéterminée et composée de vingt-quatre impulsions radiofréquence de 90° ayant les phases relatives :
-Y, X, -Y, -Y, X, -Y, Y, X, Y, Y, X, Y, -Y, -X, -Y, -Y, -X, -Y, Y, -X, Y, Y, -X, Y dans lesquelles la phase d'une impulsion X diffère de la phase d'une impulsion Y de 90°, la phase d'une impulsion X diffère de la phase d'une impulsion -X de 180° et la phase d'une impulsion Y diffère de la phase d'une impulsion -Y de 180°, la fréquence de rotation d'échantillon est ajustée de façon que la période de rotation est un multiple entier 1 de la durée en temps de la séquence à impulsion radiofréquence, et un spectre est enregistré après un multiple entier 1 de séquences d'impulsion pour une édition spectrale.

**2.** Procédé d'édition spectrale selon la revendication 1, dans lequel la première nucléide est irradiée par une radiation à polarisation croisée à la fréquence gyromagnétique de la première nucléide, pendant une première durée en temps prédéterminée, et la deuxième nucléide est irradiée par une radiation à polarisation croisée à une fréquence gyromagnétique de la deuxième nucléide, pendant une deuxième durée en temps prédéterminée.

**3.** Procédé d'édition spectrale selon la revendication 2, dans lequel la deuxième durée en temps prédéterminée est égale à la première durée en temps prédéterminée.

**4.** Procédé d'édition spectrale selon la revendication 2, dans lequel une radiation à polarisation croisée d'impulsions R.F. ou d'onde continu est appliquée à chacune des premières et deuxièmes nucléides et, après que la radiation à polarisation croisée à été arrêtée, une magnétisation transversale est détectée à partir de la deuxième nucléide pendant qu'une radiation de découplage est appliquée à la première nucléide.

**5.** Procédé d'édition spectrale selon la revendication 4, dans lequel l'irradiation de la première nucléide par radiation de découplage à la fréquence gyromagnétique de la première nucléide est temporairement interrompue et ensuite reprise.

**6.** Procédé d'édition spectrale selon l'une quelconque des revendications précédentes, dans lequel la première nucléide est un proton et la deuxième nucléide est un noyau de carbone.

**7.** Procédé d'édition spectrale selon l'une quelconque des revendications précédentes, dans lequel la fréquence de rotation d'échantillonnage est ajustée de sorte que la période de rotation est égale à trois fois la durée en temps de séquence à impulsion de radiofréquence.

FIG. 1A

FIG. 1B

EP 0 507 288 B1

Fig. 2A

Fig. 2B

Fig. 2C

Fig. 2D

400

10

Fig. 3A

Fig. 3B

Fig. 3C

Fig. 3D

SIGNAL AMPLITUDE

FREQUENCY

100    95    90    85    80    75    70    65    60
                        PPM

Fig. 4A

Fig. 4B

Fig. 4C

Fig. 4D

SIGNAL AMPLITUDE

200   180   160   140   120   100   80   60   40   20
PPM

FREQUENCY